Europäisches Patentamt

European Patent Office

Office européen des brevets

(19)

(11) **EP 1 393 133 B1**

(12) **EUROPEAN PATENT SPECIFICATION**

(45) Date of publication and mention
of the grant of the patent:
**26.10.2005  Bulletin 2005/43**

(21) Application number: **02715388.1**

(22) Date of filing: **04.01.2002**

(51) Int Cl.⁷: **G03F 7/20**

(86) International application number:
**PCT/EP2002/000030**

(87) International publication number:
**WO 2002/056114 (18.07.2002 Gazette 2002/29)**

(54) **PROJECTION SYSTEM FOR EUV LITHOGRAPHY**

PROJEKTIONSSYSTEM FÜR DIE EXTREM-ULTRAVIOLETTLITHOGRAPHIE

SYSTEME DE PROJECTION POUR LITHOGRAPHIE PAR UV EXTREME

(84) Designated Contracting States:
**DE FR GB NL**

(30) Priority: **09.01.2001  US 260799 P**

(43) Date of publication of application:
**03.03.2004  Bulletin 2004/10**

(73) Proprietor: **Carl Zeiss SMT AG**
**73446 Oberkochen (DE)**

(72) Inventors:
• **MANN, Hans-Jürgen**
**73447 Oberkochen (DE)**
• **HUDYMA, Russell**
**San Ramon, CA 84583-4905 (US)**

(74) Representative: **Sawodny, Michael-Wolfgang et al**
**Adolf - Lüken - Höflich - Sawodny,**
**Dreiköniggasse 10**
**89073 Ulm (DE)**

(56) References cited:
**EP-A- 0 779 528          WO-A-99/57596**
**WO-A-02/148796          DE-A- 19 948 240**
**US-A- 4 757 354**

• **PATENT ABSTRACTS OF JAPAN vol. 12, no. 216 (P-719), 21 June 1988 (1988-06-21) & JP 63 014112 A (MATSUSHITA ELECTRIC IND. CO., LTD.), 21 January 1988 (1988-01-21)**

EP 1 393 133 B1

**Description**

BACKGROUND OF THE INVENTION

1. Field of the Invention

The invention relates to an optical projection system for extreme ultraviolet (EUV) lithography, particularly including six mirrors arranged in two optical groups.

2. Description of the Related Art

It is widely accepted that current deep ultraviolet (DUV) projection printing systems used in a step and scan mode will be able to address the needs of the semiconductor industry for the next two or three device nodes. The next generation of photolithographic printing systems will use exposure radiation having soft x-ray or extreme ultraviolet wavelengths of approximately 11 nm to 15 nm, also in a step and scan printing architecture. To be economically viable, these next generation systems will require a sufficiently large numerical aperture to address sub 70 nm integrated circuit design rules. Further, these photolithography systems will require large fields of view in the scan direction to ensure that the throughput (defined in terms of wafers per hour) is sufficiently great so that the process is economically viable.

The theoretical resolution (R) of a lithographic printing system can be expressed by the well-known relationship $R = k_1 \lambda / NA$, where $k_1$ is a process dependent constant, $\lambda$ is the wavelength of light, and NA is the numerical aperture of the projection system. Knowing that EUV resists support a $k_1$-factor of ~0.5 and assuming a numerical aperture of 0.20, an EUV projection system can achieve a theoretical resolution on the order of approximately 30 nm with $\lambda = 13.4$ nm. It is recognized in the present invention that all reflective projection systems for EUV lithography for use in a step and scan architecture having both a large numerical aperture (0.20 to 0.30) and a large field (2 to 3 mm) are desired to address the sub-50 nm linewidth generations as defined by the International Sematech's International Technology Roadmap for Semiconductors (1999).

Four-mirror projection systems, such as those described in United States patents no. 5,315,629 and 6,226,346, issuing to Jewel and Hudyma, respectively, lack the degrees of freedom necessary to correct aberrations over a sufficiently large NA to achieve 30 nm design rules. The '346 patent teaches that a four-mirror projection system can be used to correct aberrations at a numerical aperture up to 0.14, which supports 50 nm design rules. However, it is desired that the width of the ring field be reduced to enable wavefront correction to the desired level for lithography. The '346 patent demonstrates that the ring field is reduced from 1.5 mm to 1.0 mm as a numerical aperture is increased from 0.10 to 0.12. Further scaling of the second embodiment in the' 346 patent reveals that the ring field must be reduced to 0.5 mm as a numerical aperture is increased further to 0.14. This reduction in ring field width results directly in reduced throughput of the entire projection apparatus. Clearly, further advances are needed.

Five-mirror systems, such as that set forth in United States patent no. 6,072,852, issuing to Hudyma, have sufficient degrees of freedom to correct both the pupil dependent and field dependent aberrations, thus enabling numerical apertures in excess of 0.20 over meaningful field widths (> 1.5 mm). While minimizing the number of reflections has several advantages particular to EUV lithography, an odd number of reflections create a problem in that new stage technology would need to be developed to enable unlimited parallel scanning. To "unfold" the system to enable unlimited synchronous parallel scanning of the mask and wafer with existing scanning stage technologies, it is recognized herein that an additional mirror should be incorporated into the projection system.

Optical systems for short wavelength projection lithography utilizing six or more reflections have been disclosed in the patent literature. One such early system is disclosed in U.S. Pat. No. 5,071,240, issuing to Ichihara and Higuchi entitled, "Reflecting optical imaging apparatus using spherical reflectors and producing an intermediate image." The '240 patent discloses a 6-mirror catoptric or all-reflective reduction system utilizing spherical mirrors. This particular embodiment is constructed with three mirror pairs and uses positive/negative (P/N) and negative/positive (N/P) combinations to achieve the flat field condition. Ichihara and Higuchi also demonstrate that the flat field imaging condition (zero Petzval sum) can be achieved with a system that utilizes an intermediate image between the first mirror pair and last mirror pair. The patent teaches the use of a convex secondary mirror with an aperture stop that is co-located at this mirror. It is also clear from examination of the embodiments that the '240 patent teaches the use of low incidence angles at each of the mirror surfaces to ensure compatibility with reflective coatings that operate at wavelengths around 10 nm.

While the embodiments disclosed in the '240 patent appear to achieve their stated purpose, these examples are not well suited for contemporary lithography at extreme ultraviolet wavelengths. First, the systems are very long (~ 3000 mm) and would suffer mechanical stability problems. Second, the embodiments do not support telecentric imaging at the wafer which is desired for modem semiconductor lithography printing systems. Lastly, the numerical aperture is rather small (~ 0.05) leaving the systems unable to address 30 nm design rules.

Recently, optical projection production systems have been disclosed that offer high numerical apertures with at least six reflections designed specifically for EUV lithography. One such system is disclosed in United States patent number 5,815,310, entitled, "High numerical aperture ring field optical projection system, " issuing to Williamson. In the '310 patent, Williamson describes a six-mirror ring field projection system intended for use with EUV radiation. Each of the mirrors is aspheric and share a common optical axis. This particular embodiment has a numerical aperture of 0.25 and is capable of 30 nm lithography using conservative (~0.6) values for $k_1$. This particular embodiment consists, from long conjugate to short conjugate, of a concave, convex, concave, concave, convex and concave mirror, or PNPPNP for short.

The preferred EUV embodiment disclosed in the '310 patent suffers from several drawbacks, one of which is the high incidence angles at each of the mirrored surfaces, particularly on mirrors M2 and M3. In some instances, the angle of incidence exceeds 24° at a given location on the mirror. Both the mean angle and deviation or spread of angles at a given point on a mirror surface is sufficient to cause noticeable amplitude and phase effects due to the EUV multilayer coatings that might adversely impact critical dimension (CD control).

Two other catoptric or all-reflective projection systems for lithography are disclosed in United States patent number 5,686,728 entitled, "Projection lithography system and method using all-reflective optical elements," issuing to Shafer. The '728 patent describes an eight mirror projection system with a numerical aperture of about 0.50 and a six-mirror projection system with a numerical aperture of about 0.45 intended for use at wavelengths greater than 100 nm. Both systems operate in reduction with a reduction ratio of 5x. Like the systems described in the '310 patent, these systems have an annular zone of good optical correction yielding lithography performance within an arcuate shaped field. While these systems were designed for DUV lithography and are fine for that purpose, these embodiments make very poor EUV projection systems. Even after the numerical aperture is reduced from 0.50 to 0.25, the incidence angles of the ray bundles are very large at every mirror including the mask, making the system incompatible with either Mo/Si or Mo/Be multilayers. In addition, both the aspheric departure and aspheric gradients across the mirrors are rather large compared to the EUV wavelength; calling into question whether or not such aspheric mirrors can be measured to a desired accuracy for EUV lithography. Recognizing these issues, the '728 patent explicitly teaches away from using catoptric or all-reflective projection systems at EUV wavelengths and instead restricts their use to longer DUV wavelengths.

Another projection system intended for use with EUV lithography is disclosed in U.S. Patent No. 6,033,079, issuing to Hudyma. The '079 patent entitled, "High numerical aperture ring field projection system for extreme ultraviolet lithography," describes two preferred embodiments. The first embodiment that the -079 patent describes is arranged with, from long to short conjugate, a concave, concave, convex, concave, convex, and concave mirror surfaces (PPNPNP). The second preferred embodiment from the '079 patent has, from long to short conjugate, a concave, convex, convex, concave, convex, and concave mirror surfaces (PNNPNP). The '079 patent teaches that both PPNPNP and PNNPNP reimaging configurations are advantageous with a physically accessible intermediate image located between the fourth and fifth mirror. In a manner similar to the '240 and '310 patents, the '079 patent teaches the use of an aperture stop at the secondary mirror and a chief ray that diverges from the optical axis after the secondary mirror.

The '079 patent teaches that the use of a convex tertiary mirror enables a large reduction in low-order astigmatism. This particular arrangement of optical power is advantageous for achieving a high level of aberration correction without using high incidence angles or extremely large aspheric departures. For both embodiments, all aspheric departures are below 15 μm and most are below 10 μm. Like the '240 patent, the '079 patent makes a significant teaching related to EUV via the use of low incidence angles on each of the reflective surfaces. The PPNPNP and PNNPNP power arrangements promote low incidence angles thus enabling simple and efficient EUV mirror coatings. The low incidence angles work to minimize coating-induced amplitude variations in the exit pupil, minimize coating-induced phase or optical path difference (OPD) variations in the exit pupil, and generally lower the tolerance sensitivity of the optical system. These factors combine to promote improved transmittance and enhanced CD uniformity in the presence of variations in focus and exposure.

While the prior art projection optical systems have proven adequate for many applications, they're not without design compromises that may not provide an optimum solution in all applications. Therefore, there is a need for a projection optical system that can be used in the extreme ultraviolet (EUV) or soft X-ray wavelength region that has a relatively large image field with capable of sub 50 nm resolution.

From US 4,757,354 a projection optical system for photolithography is known, which includes a refraction sub-system and a cata-dioptric sub-system optically connected to each other. The cata-dioptric sub-system is generally composed of a face compensating member a concave mirror and convex mirror.

From DE 199 48 240 a microlithographie-reduction objective has been made known comprising six mirrors. The numerical aperture of this systems is greater than 0,15 and the mirror next to the wafer has a distance greater than 50 mm, preferably greater than 60 mm to the plane in which the wafer is situated.

WO 99/57596 discloses a mirror projection system for use in a step- and scan-lithographic projection apparatus having six imaging mirrors. The mirror projection system is such that no intermediate image is formed and the system has a negative magnification.

EP-A-0779528 shows a six-mirror optical projection reduction system having a first mirror pair, a second field mirror pair and a third mirror pair.

From the WO 02/48796 which is published after the filing date of this application, also an EUV optical projection system comprising a least six reflecting surfaces for imaging an object on an image is known.

SUMMARY OF THE INVENTION

In view of the above, an EUV optical projection system is also provided including at least sic reflecting surfaces for imaging an object, wherein al least one mirror pair is configured as an at least partially phase compensating mirror pair which provides compensation for multiplayer-induced phase errors. The mirror pair may include preferably the second and fifth mirrors. A mirror pair is at least partially phase compensating if the difference of the mean incidence angles of a ray bundle from a central field point at the mirror of the least partially phase compensating mirror pair is minimized. This difference should be less than 5°, preferably less than 4°. The difference in incidence angle variation in the tangential plane across the mirrors of the al least partially phase compensating mirror pair for said ray bundle should be also minimized. This difference should be less than 5°, preferably 4°.

The system as defined in claim 6 may include an aperture stop located along an optical path from the object to the image between a first mirror and a second mirror. The aperture stop may be disposed off each of the first mirror and the second mirror. The second mirror may be convex, while the third mirror may be concave.

In further view of the above, the EUV optical projection system is also provided including at least six reflecting surfaces for imaging a object, and an aperture stop located along an optical path from the object to the image between a first mirror and a second mirror. The second mirror is convex, and the third mirror is concave. The aperture stop may be disposed off each of the first mirror and the second mirror. The system includes at least one mirror pair configured as an at least partially phase compensating mirror pair which provides compensation for multiplayer-included phase mirror. The mirror pair may include the second and fifth mirrors.

The system may be further configured to form an intermediate image along an optical path from the object to the image between a second mirror and a third mirror as defined to claim 12, such that a first mirror an the second mirror form a first optical group and the third mirror, a fourth mirror, a fifth mirror and a sixth mirror form a second optical group. A magnification ratio of the first optical group may be between -0.8 and -1.2, and a magnification ratio of the second optical group may be between -0.15 and - 0.35.

In further view of the above, the EUV optical projection system is also provided including at least six reflecting surfaces for imaging an object, wherein an intermediate image is formed along an optical path from the object to the image between a second mirror and a third mirror, such that a first mirror and the second mirror form a first optical group and the third mirror, a fourth mirror, a fifth mirror and a sixth mirror form a second optical group. The second mirror is convex, while the third mirror is concave.

The system may further include an aperture stop located along the optical path from the object to the image between the first mirror and the second mirror. The aperture stop may be disposed off each of the first mirror and the second mirror. The system may also include at least one mirror pair configured as an at lease partially phase compensating mirror pair that compensates for multiplayer-induced phase errors. The mirror pair may include the second and fifth mirrors.

Any of these systems may be further configured such that a chief ray diverges away from the optical axis while propagating between the second mirror and the third mirror. The first mirror may be preferably concave, the second mirror convex, the third mirror concave, the fourth mirror concave, the fifth mirror convex and the sixth mirror concave. The physical distance between the object and the image may be substantially 1500 mm or less. An image is preferably formed with a numerical aperture greater than 0.18.

Each of the six reflecting surfaces preferably receives a chief ray from a central field point at an incidence angle of less than substantially 16°, and five of the six reflecting surfaces preferably receive a chief ray from a central field point at an incidence angle of less than substantially 13°. A bean propagating between second an third mirrors along an optical path between the object and the image and a bean propagating between fourth and fifth mirrors may preferably cross in the y-axis direction. A maximum aspheric departure of a sixth mirror along an optical path from the object to the image from a best fitting sphere may be preferably less than substantially 6 $\mu$m. The system is preferably configured to have a RMS wavefront error of 0.017$\lambda$ or less.

BRIEF DESCRIPTION OF THE DRAWINGS

Figure 1 shows a plan view of an EUV optical projection system according to a preferred embodiment.
Figure 2 schematically illustrates the geometry of the arcuate ring field according to the preferred embodiment at the object.

INCORPORATION BY REFERENCE

What follows is a cite list of references which, in addition to that which is described in the background and brief summary of the invention above, are hereby incorporated by reference into the detailed description of the preferred embodiments, as disclosing alternative embodiments of elements or features of the preferred embodiment not otherwise set forth in detail below. A single one or a combination of two or more of these references may be consulted to obtain a variation of the preferred embodiments described below. Further patent, patent application and non-patent references, and discussion thereof, cited in the background and/or elsewhere herein are also incorporated by reference into the detailed description of the preferred embodiments with the same effect as just described with respect to the following references:

U.S. patents no. 5,063,586, 5,071,240, 5,078,502, 5,153,898, 5,212,588, 5,220,590, 5,315,629, 5,353,322, 5,410,434, 5,686,728, 5,805,365, 5,815,310, 5,956,192, 5,973,826, 6,033,079, 6,014,252, 6,188,513, 6,183,095, 6,072,852, 6,142,641, 6,172,825, 6,226,346, 6,255,661 and 6,262,836;
European patent applications no. 0 816 892 A1 and 0 779 528 A; and
"Design of Reflective Relay for Soft X-Ray Lithography", J. M. Rodgers, T.E. Jewell, International Lens Design Conference, 1990;
"Reflective Systems design Study for Soft X-ray Projection Lithography", T.E. Jewell, J.M. Rodgers, and K.P. Thompson, J. Vac. Sci. Technol., November/December 1990.
"Optical System Design Issues in Development of Projection Camera for EUV Lithography", T.E. Jewell, SPIE Volume 2437, pages 340-347;
"Ring-Field EUVL Camera with Large-Etendu", W.C. Sweatt, OSA TOPS on Extreme Ultraviolet Lithography, 1996; and
"Phase Shifting Diffraction Interferometry for Measuring Extreme Ultraviolet Optics", G.E. Sommargaren, OSA TOPS on Extreme Ultraviolet Lithography, 1996;
"EUV Optical Design for a 100 nm CD Imaging System", D.W. Sweeney, R. Hudyma, H.N. Chapman, and D. Shafer, SPIE Volume 3331, pages 2-10.

DETAILED DESCRIPTION OF THE PREFERRED EMBODIMENTS

The specific preferred embodiment relating to this optical projection system is described.

Preferred Embodiment

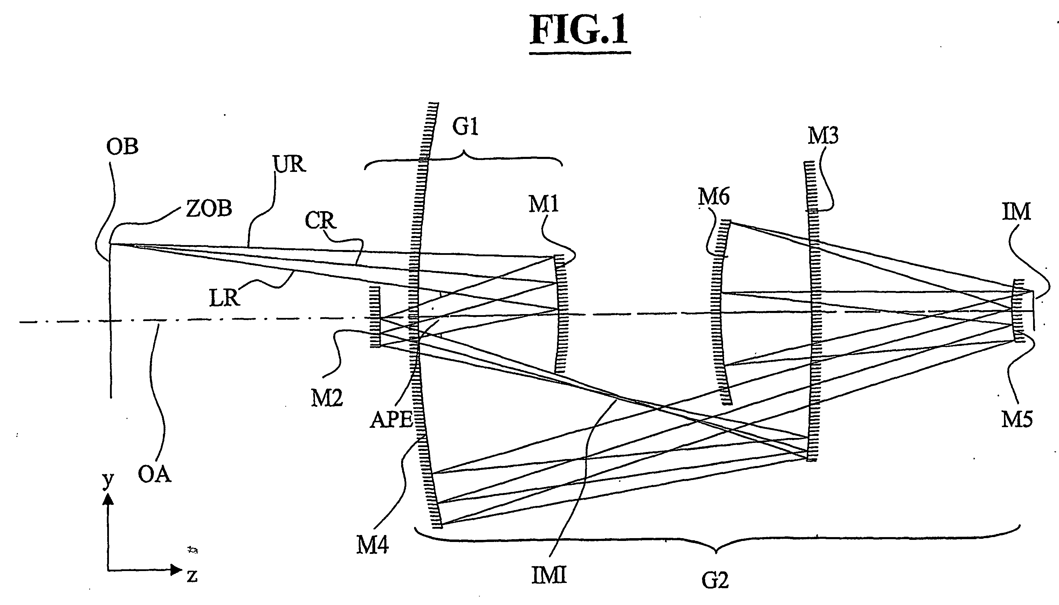

Figure 1 schematically illustrates a first preferred embodiment, and, taking in conjunction with Table 1 and Table 2, provides an illustrative, exemplary description of this embodiment. Light impinges on an object OB, e.g. a reflective mask or a reticle, from an illumination source and is directed to concave mirror M1 after which it reflects from the mirror and passes through a physically accessible aperture stop APE that is located between mirror M1 and mirror M2. This aperture stop APE is a substantial distance from the first concave mirror M1 and, likewise, this aperture stop APE is located a substantial distance from convex mirror M2. After the illumination reflects off convex mirror M2, the light comes to a focus at an intermediate image IMI that is located in close proximity to concave mirror M3. From mirror M3 the illumination is directed toward concave mirror M4 where the light is nearly collimated and directed toward convex mirror M5. Upon reflection from mirror M5, the light impinges on concave mirror M6 where it is reflected in a telecentric manner (the chief rays are parallel to the optical axis) and focused on an image IM. A semiconductor wafer is typically arranged at the position of the image IM. Since a concave optical surface has positive optical power (P) and a convex optical surface has negative optical power (N), this present embodiment may be characterized as a PNPPNP configuration.
Although there are many ways to characterize this optical system, one convenient way is to break the system into two groups G1 and G2. Starting at the object OB, the first group G1 is comprised the concave/convex mirror pair M1 and M2. This group forms an intermediate image IMI at a magnification of about -1x between mirror M2 and M3.

The remaining four mirrors (concave mirror M3, concave mirror M4, convex mirror M5 and concave mirror M6) comprise the second imaging or relay group G2. This second group G2 works at a magnification of approximately - 0.25x, resulting in 4x reduction (the reduction ratio is the inverse of the absolute value of the optical magnification) of the object OB at the image IM.

The optical prescription of the first embodiment of Fig. 1 is listed in Table 1 and Table 2. The aspheric mirror surfaces are labeled A(1)-A(6) in the tables with A(1) corresponding to mirror M1, A(2) corresponding to mirror M2, and so on. Four additional surfaces complete the description of this illustrative and exemplary embodiment with object OB and image IM representing the planes, where in a lithographic apparatus the mask and the wafer are arranged. A surface designation is also made for the location of the aperture stop APE and intermediate image IMI. After each surface designation, there are two additional entries listing the vertex radius of curvature (R) and the vertex spacing between the optical surfaces. In this particular embodiment, each of the surfaces is rotationally symmetric conic surface with higher-order polynomial deformations. The aspheric profile is uniquely determined by its K, A, B, C, D, and E values. Each mirror uses 4th, 6th, 8th, 10th, and 12th order polynomial deformations. The sag z of the aspheric surface (through 12th order) in the direction of the z-axis is given by:

$$z = \frac{ch^2}{1 + \sqrt{1 - (1 + k)c^2h^2}} + Ah^4 + Bh^6 + Ch^8 + Dh^{10} + Eh^{12}$$

where h is the radial coordinate; c is the vertex curvature of the surface (1/R); K is the conic constant; and A, B, C, D, and E are the 4th, 6th, 8th, 10th, and 12th order deformation coefficients, respectively. These coefficients are listed in Table 2.

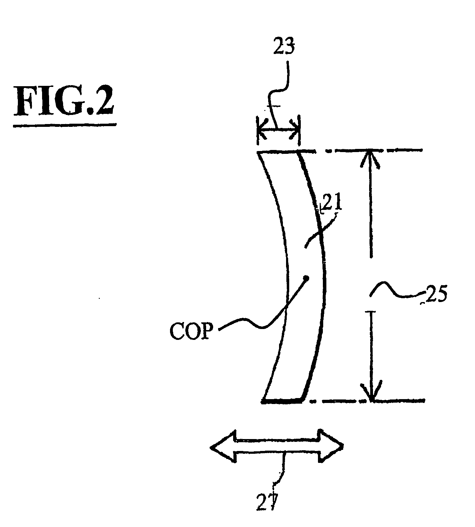

The optical system of this first preferred embodiment is designed to project a ring field format that is illuminated with extremely ultraviolet (EUV) or soft X-ray radiation. The numerical aperture at the object (NAO) is 0.055 radians; at a 4x reduction this corresponds to a numerical aperture NA of 0.22 at the image, which exceeds 0.18 as a desired threshold value. The ring field 21 at the object OB is shown with Figure 2. It is centered at 120 mm from the optical axis OA, which contains the vertex of each of the aspheric mirrors. This annular field extends from 116 mm to 124 mm forming an arcuate slit with a width 23 of 8 mm. The extent 25 of the ring field 21 perpendicular to the scan direction 27 becomes 104mm. The central field point is denoted with the reference sign COP. At 4x reduction, this ring field becomes 2.0 mm wide in the scan direction at the image IM.

As a result of the distribution of optical power and location of the aperture stop APE, the incidence angles are well controlled so that the design is compatible with EUV or soft X-ray multilayer coatings. As measured by the chief ray CR from the central field point COP, this system exhibits very low incidence angles ranging from 3.1° to 14.6°. The chief ray incidence angles from the central field point COP are: object OB: 5.7°; M1: 9.9°; M2: 14.6°; M3: 11.0°; M4: 4.4°, M5: 11.0°, and M6: 3.1°. Advantageously, each of the six mirrors receives a chief ray CR from a central field point COP at an incidence angle of less than substantially 16°, and five of the six mirrors receives a chief ray CR from a central field point COP at an incidence angle of less than substantially 13°. These low incidence angles are a key enabling element for EUV lithography since (1) they minimize the multilayer induced amplitude and phase errors that have an adverse impact to lithographic performance and (2) enable simplified coating designs that do not rely heavily on the use of laterally graded coating profiles. With poor design (i.e., failure to minimize these incidence angles), these multilayer-induced amplitude and phase errors can lead to critical dimension (CD) errors that are easily greater than 20% of the nominal linewidth, making the system unusable for production applications.

Besides the low incidence angles, a preferred system further enables EUV lithography by utilizing mirrors with low peak aspheric departure. The maximum peak departure (as measured across the instantaneous clear aperture), contained on mirror M1, is 36 μm. The other mirrors have low-risk aspheres with departures that range from 2.5 μm to 14.0 μm. The low aspheric departures of the mirror surfaces facilitate visible light metrology testing without a null lens or Computer Generated Hologram (CGH), resulting in surface figure testing to a high degree of accuracy. An aspheric mirror with a very large peak departure is unproducible because it cannot be measured to the required accuracy to realize lithographic performance.

Table 3 summarizes the performance of the PNPPNP configuration of Fig. 1. The table demonstrates that this preferred embodiment is able to achieve lithographic performance with a resolution on the order of 30 nm (assuming a k1-factor of approximately 0.5). This performance is achieved by manipulating the balance of aberrations between the imaging groups G1 and G2. The PNPPNP is arranged so that the third order tangential astigmatism from the second group G2 (ignoring aspheric contributions to the third order aberration coefficients for the moment) is made very small. The coma contribution from the second group G2, again ignoring aspheric contributions, is overcorrected and large. Within the first group G1 group, the location of the aperture stop is selected so that the third order coma contribution from the PN pair is nearly balanced and the tangential astigmatism contribution from the convex secondary mirror M2 itself is made very small. Taking into account the aspheric contribution to the third order aberration coefficient, the strong hyperbolic profile on mirror M1 impacts a strongly undercorrected astigmatic contribution as well as a strongly undercorrected coma contribution. These contributions help to balance the low order aberrations between the groups G1 and G2, with the higher-order aspheric deformations on the mirrors themselves contributing to fine correction and aberration balance that allows the residual wavefront error (the departure of converging wavefront from an ideal reference sphere centered on the image field point) to remain exceedingly small. In fact, aberration correction and resulting aberration balance reduces the composite RMS wavefront error is only 0.011$\lambda$ (0.15 nm), with simultaneous correction of the static distortion to less than 1.5 nm across the field.

As mentioned above, the first optical group G1 of the preferred system includes the first mirror M1 and the second mirror M2, and forms an intermediate image IMI of the object OB. The intermediate image IMI of the object OB is preferably formed with a magnification somewhere within a range around unity, e.g., between -0.8 and -1.2. For example, the magnification of the intermediate image IMI formed by the first optical group G1 of the object OB schematically illustrated at Figure 1 is particularly approximately -1.02, which is a small expansion magnification. The system may be configured such that the first optical group G1 provides a small reduction magnification (e.g., between -0.8 and -1.0), a small expansion magnification (e.g., between -1.0 and -1.2), or substantially unity magnification.

The second optical group G2 includes the third through sixth mirrors M3-M6, respectively, and forms the image IM from the intermediate image IMI. The image IM is preferably formed with a magnification of the intermediate image IMI within a range around -0.25, e.g., between -0.15 and -0.35. For example, the magnification of the image IM formed by the second optical group G2 of the intermediate image IMI is particularly approximately -0.25. The overall magnification of the image IM formed by the system including the first and second optical groups G1 and G2 is therefore preferably around +0.25, or a 4x reduction as mentioned above. The substantial reduction of the image IM from the object OB is notably performed by the second optical group G2.

Since astigmatism is the dominant aberration to be corrected, the preferred embodiment utilizes a novel arrangement to influence the third-order (Seidel) astigmatism correction. The preferred embodiment is arranged so that the third order tangential astigmatism from the mirrors M3-M6 of the second optical group G2 is corrected (the Seidel sum approaches zero). To further minimize tangential astigmatism, the advantageous location of the aperture stop APE is selected so that the tangential astigmatism from the convex secondary mirror M2 is corrected (the Seidel contribution approaches zero). This construction enables the use of low departure/low gradient aspheres, especially on mirror M6 where aspheric departure from the best fit sphere across the clear aperture is around 4 $\mu$m in the system of the preferred embodiment as illustrated at Table 3. This sixth mirror M6 is the largest mirror in the six mirror system. The advantageously low aspheric departure of the sixth mirror M6 provides a far easier system to manufacture and test. The aspheric departure of the sixth mirror M6 according to the preferred embodiment may have an aspheric departure within a range below 6 $\mu$m, and preferably between 2 $\mu$m and 6 $\mu$m.

This optical projection system has further benefits in that the system of Fig. 1 may be scaled in either numerical aperture or field. For example, it is desirable to scale this concept to larger numerical aperture to improve the modulation in the aerial image thus allowing 30 nm resolution with a less aggressive k1-factor. The results of a simple scaling experiment demonstrate that this preferred embodiment easily supports such scaling to larger numerical apertures. Without making any modifications, an analysis of the composite root mean square (RMS) wavefront error was made at a numerical aperture of 0.25, which represents a 14% increase to the value shown in Table 3. The composite RMS wavefront error was found to be 0.033$\lambda$ (0.44 nm), a level that supports lithographic quality imaging.

Referring to Fig. 2, it is desirable to increase the field of view in the scan direction to increase the number of wafers per hour (WPH) that the lithographic apparatus can process. The idea is that more area can be printed per unit time with a wider arcuate slit. The results of another simple scaling experiment demonstrate that this preferred embodiment easily supports increases in field width. Without making any modifications, an analysis of the composite RMS wavefront error was made over a 3 mm wide arcuate slit, which represents a 50% increase to the value shown in Table 3. The composite RMS wavefront error was found to be 0.021 $\lambda$ (0.28 nm), again a level that supports lithographic quality imaging.

The preferred embodiment depicted at Figure 1 enables partial compensation for the degradation to the wavefront error due to the multilayer coatings. This partial phase compensation is particularly enabled by the design between mirror M2 and mirror M5. Multilayer phase effects that are due to large mean incidence angles on these surfaces are advantageously at least partially compensated in the system of the preferred embodiment. The preferred system is constructed to provide means for correcting these errors primarily using two constructions. First, the mean incidence angles of the ray bundle from the central field point COP at mirror M2 and mirror M5 are set to be nearly the same. The ray bundle is delimited in the tangential plane by the upper rim ray UR and the lower rim ray LR. The tangential plane is shown in Figure 1 as the y-z-plane. For this preferred embodiment, the mean incidence angle at mirror M2 is around 14.6°, while the mean incidence angle at mirror M5 is around 11.0°. The angles do not have to be exactly the same, but their difference should be less than 5°, preferably less than 4°. Second, the difference in incidence angle variation across mirror M2 and mirror M5, as seen in the tangential plane, is minimized by varying the location of the secondary mirror M2 with respect to the aperture stop APE in combination with the location of the intermediate image IMI. For the preferred embodiment, the incidence angle variation in the tangential plane across mirror M2 is about 6°, while the incidence angle variation across mirror M5 is about 8.7°. The difference of the incidence angle variation should be less than 5°, preferably less than 4°. In the preferred embodiment the difference is 2.7° for an image-side numerical aperture NA of 0,22.

Referring to Table 4, the upper rim ray UR undergoes a higher phase change than the lower rim ray LR at mirror M2 due to the incidence angle of the upper rim ray UR (17.4°) being greater than that for the lower rim ray LR (11.4°). The difference between the incidence angles at M2 for UR and LR is then +6.0°. As the ray bundle propagates through the intermediate image IMI, the same upper ray UR that hits M2 above the lower ray LR, will,strike M5 below where the lower ray LR strikes M5. The upper ray UR and lower ray LR change their relative positions along the y-axis after the formation of the intermediate image IMI. The upper ray UR, which strikes mirror M5 below the lower ray LR, will undergo a smaller phase change than the lower ray LR at mirror M5 due to the incidence angle of the upper ray UR (6.4°) being smaller than that for the lower ray LR (15.1 °). The difference between the incidence angles at M5 for UR and LR is then -8.7°. It is in this manner that a good measure of phase compensation between mirror M2 and mirror M5 is achieved, as Table 4 shows. A uniform Mo/Si multilayer coating (e.g., 40 bilayer pairs with bilayer thickness of 7.04 nm) may be typically applied to both mirror M2 and mirror M5. This Mo/Si multilayer induces a peak to valley phase error (which is identically equivalent to an optical path difference or wavefront error) of $-0.406\lambda$ (5.44 nm) from M2, and a peak to valley phase error of $+0.484\lambda$ (6.49 nm) from M5. The net phase change is thus reduced from $\sim 0.500\lambda$ to only $0.078\lambda$ (1.05 nm) using this advantageous phase compensation technique in accord with the preferred embodiment. This residual phase error can be corrected with a modest amount of local optimization. This method represents a striking advantage over a system wherein wavefront errors are not compensated between mirror pairs and may instead add together to produce enhanced errors. The technique can be alternatively used to reduce the multiplayer-induced phase errors to around or below $0.125\lambda$, to a level where modest local optimization can then be used to improve performance to lithographic levels.

As illustrated at Figure 1, the system of the preferred embodiment includes the additional feature that the beam propagating between mirror M2 to mirror M3 and the beam propagating between mirror M4 and mirror M5 cross each other in the y-axis. In combination with the feature of the preferred embodiment that the intermediate image IMI is located between M2 and M3, this beam crossing feature works in conjunction with the compactness feature of the system, facilitates the handling of distortion and maintenance of low incidence angles, and provides substantial beam clearance. The beam crossing feature also works favorably with the high numerical aperture (e.g., above 0.18 and more preferably above around 0.20-0.25) of the system of the preferred embodiment.

The beam crossing occurs in such a way that the intermediate image IMI and the center of curvature of mirror M3 each lie to the left (in Figure 1) of the vertex of M3. In a like manner, a real image would form after M4 if mirror M5 and mirror M6 were taken away. The center of curvature of M4 and this real image that would be formed with M5 and M6 taken out of the way would lie to the right of the vertex of M4. In this way, the mean incidence angles on both M3 and M4 are minimized.

The beam crossing arrangement permits the design to be scaled in either numerical aperture of field without "restrictions." In other words, there is plenty of beam clearance around mirrors M3 and M4. This also allows greater versatility in the design. This substantial beam clearance is facilitated by the beam crossing feature of the preferred embodiment, above that which would be expected in a system not having beam crossing.

The beam crossing of the preferred embodiment has the additional advantage that the optical distance between mirrors M3 and M4 and that between mirrors M4 and M5 may be increased, thus allowing the incidence angles to be reduced. Moreover and as mentioned briefly above, beam crossing facilitates the compactness feature of the preferred embodiment (i.e., preferably less than two meters and particularly around 1500 mm or less along the z-axis between the object and the image). Due to the space required for mirror mounts, and particularly that of mirror M4, the beam crossing feature of the preferred embodiment facilitates the realization of a compact, high numerical aperture system, and even more advantageously, a preferred system having significantly low incidence angles.

The optical design descriptions provided above for the preferred embodiment demonstrate an advantageous catoptric projection system concept for EUV lithography. While these embodiments have been particularly described for use in a 13.4 nm tool, the basic concept is not limited to use with lithographic exposure tools at this wavelength, either shorter or longer, providing a suitable coating material exists in the soft x-ray region of the electromagnetic spectrum.

While exemplary drawings and specific embodiments of the present invention have been described and illustrated, it is to be understood that that the scope of the present invention is not to be limited to the particular embodiments discussed. Thus, the embodiments shall be regarded as illustrative rather than restrictive, and it should be understood that variations may be made in those embodiments by workers skilled in the arts without departing from the scope of the present invention as set forth in the claims that follow, and equivalents thereof. For example, one skilled in the art may reconfigure the embodiments described herein to expand the field of view, increase the numerical aperture, or both, to achieved improvements in resolution or throughput.

Table 1.

| Optical prescription preferred embodiment | | | |
|---|---|---|---|
| Element number | Vertex radius of curvature | Thickness (mm) | Glass |
| Object OB | INFINITY | 723.7539 | |
| A(1) | -643.5439 | -192.7897 | REFL |
| Aperture Stop APE | INFINITY | -99.4340 | |
| A(2) | -2742.4833 | 363.1533 | REFL |
| Intermediate image IMI | INFINITY | 343.7066 | |
| A(3) | -2850.8680 | -644.4521 | REFL |
| A(4) | 1471.8440 | 971.0620 | REFL |
| A(5) | 252.1454 | -475.4847 | REFL |
| A(6) | 558.1165 | 510.4847 | REFL |
| Image IM | | | |

Table 2.

| Aspheric prescription | | | | | | |
|---|---|---|---|---|---|---|
| Aspheric | K | A | B | C | D | E |
| A(1) | -1.0232 | 2.3506E-09 | -5.2889E-14 | 1.1199E-18 | -2.2037E-23 | 4.1964E-28 |
| A(2) | -207.7484 | 1.0280E-09 | 2.5446E-14 | 6.3412E-18 | -2.2982E-21 | 3.2649E-25 |
| A(3) | -3.9282 | 1.0123E-10 | 8.1343E-17 | -1.5369E-20 | 3.5192E-25 | -3.4955E-30 |
| A(4) | 0.1886 | 1.9835E-11 | -1.8278E-16 | 2.1374E-21 | -1.4503E-26 | 5.3855E-32 |
| A(5) | 0.9822 | -1.3413E-08 | 9.1993E-13 | -2.2661E-17 | -5.9605E-22 | 2.6224E-25 |
| A(6) | 0.0814 | -2.4749E-11 | -5.9262E-17 | -1.2870E-23 | -1.4070E-26 | 6.3467E-31 |

Table 3.

| Performance summary preferred embodiment | | |
|---|---|---|
| Metric | | Performance |
| Wavelength | | 13.4 nm |
| Numerical aperture (image) | | 0.22 |
| Ringfield format (image) i. ii. iii. | Radius Width Chord | 30.0 mm 2.0 mm 26.0 mm |
| Reduction ratio (nominal) | | 4:1 |
| Overall length (mm) | | 1500 mm |
| RMS wavefront error (waves @ $\lambda$ = 13.4 nm) i. ii. | Composite Variation | 0.011$\lambda$ 0.007$\lambda$ - 0.014$\lambda$ |
| Chief ray distortion | | < 1.5 nm |

Table 3.   (continued)

| Performance summary preferred embodiment | | |
|---|---|---|
| Metric | | Performance |
| Exit pupil location | | Infinity |
| Max. aspheric departure across Instantaneous clear aperture (ICA) | | |
| i. | M1 | 36.0 μm |
| ii. | M2 | 2.5 μm |
| iii. | M3 | 9.4 μm |
| iv. | M4 | 14.0 μm |
| v. | M5 | 2.7 μm |
| vi. | M6 | 4.0 μm |

## Table 4. phase compensation

| Mirror | AOI upper rim ray (UR) | Mean AOI | AOI lower rim ray (LR) | AOI variation across | Phase error (waves, $\lambda$ =13.4 nm) |
|---|---|---|---|---|---|
| M2 | 17.4° | 14.6° | 11.4° | 6.0° | -0.406$\lambda$ |
| M5 | 6.4° | 11.0° | 15.1° | -8.7° | +0.484$\lambda$ |
| | | | | Sum | +0.078$\lambda$ |

**Claims**

1. An EUV optical projection system, comprising:

   at least six mirrors (M1, M2, M3, M4, M5, M6) for imaging an object (OB) to an image (IM), and
   wherein at least one mirror pair is further configured as an at least partially phase compensating mirror pair.

2. The system of Claim 1, wherein said at least partially phase compensating mirror pair comprises the second mirror (M2) and the fifth mirror (M5) along an optical path from the object (OB) to the image (IM).

3. The system of any of Claims 1 or 2, further comprising an aperture stop (APE) located along an optical path from said object (OB) to said image (IM) between a first mirror (M1) and a second mirror (M2).

4. The system of Claim 3, wherein said aperture stop (APE) is not located on the first mirror (M1), and said aperture stop (APE) is not located on the second mirror (M2).

5. The system of any of Claims 1-4, wherein a second mirror (M2) along an optical path from the object (OB) to the image (IM) is convex, and a third mirror (M3) along said optical path is concave.

6. The system of claim 1 further comprising:

   an aperture stop (APE) located along an optical path from said object (OB) to said image (IM) between a first mirror (M1) and a second mirror (M2), and
   wherein said second mirror (M2) is convex, and
   wherein a third mirror (M3) along said optical path is concave.

7. The system of Claim 6, wherein said aperture stop (APE) is not located on said first mirror (M1) and said-aperture stop (APE) is not located on said second mirror (M2).

8. The system of Claim 7, wherein said at least partially phase compensating mirror pair comprises the second mirror (M2) and the fifth mirror (M5) along the optical path.

9. The system of any of Claims 1-8, wherein said system is configured to form an intermediate image (IMI) along an optical path from the object (OB) to the image (IM) between a second mirror (M2) and a third mirror (M3), such that a first mirror (M1) and a second mirror (M2) form a first optical group (G1), and a third mirror (M3), a fourth mirror (M4), a fifth mirror (M5) and a sixth mirror (M6) form a second optical group (G2).

10. The system of Claim 9, wherein a magnification ratio of the first optical group is between -0.8 and -1.2, and a magnification ratio of the second optical group is between -0.15 and -0.35.

11. The system of claim 1 further comprising:

    wherein said system is configured to form an intermediate image (IMI) along an optical path from the object (OB) to the image (IM) between a second mirror (M2) and a third mirror (M3), such that a first mirror (M1) and the second mirror (M2) form a first optical group (G1), and the third mirror (M3), a fourth mirror (M4), a fifth mirror (M5) and a sixth mirror (M6) form a second optical group (G2), and
    wherein said second mirror (M2) is convex, and
    wherein said third mirror (M3) is concave.

12. The system of Claim 11, further comprising an aperture stop (APE) located along said optical path from said object (OB) to said image (IM) between said first mirror (M1) and said second mirror (M2).

13. The system of Claim 12, wherein said aperture stop (APE) is not located on said first mirror (M1) and said aperture stop (APE) is not located on said second mirror (M2).

14. The system of Claim 13, wherein said at least partially phase compensating mirror pair comprises the second mirror (M2) and the fifth mirror (M5).

15. The system of at least one of the preceding Claims, wherein a first mirror (M1) along an optical path from the object (OB) to the image (IM) is concave, a second mirror (M2) is convex, a third mirror (M3) is concave, a fourth mirror (M4) is concave, a fifth mirror (M5) is convex and a sixth mirror (M6) is concave.

16. The system of at least one of the preceding Claims, wherein each of said six mirrors (M1, M2, M3, M4, M5, M6) is disposed between said object (OB) and said image (IM), and wherein a physical distance between said object (OB) and said image (IM) is substantially 1500 mm or less.

17. The system of at least one of the preceding Claims, wherein said system forms an image (IM) with a numerical aperture greater than 0.18.

18. The system of Claim 17, wherein each of the six mirrors (M1, M2, M3, M4, M5, M6) receives a chief ray (CR) from a central field point (COP) at an incidence angle of less than substantially 16°.

19. The system of any of Claims 17 or 18, wherein five of the six mirrors (M1, M2, M3, M4, M5, M6) receives a chief ray (CR) from a central field point (COP) at an incidence angle of less than substantially 13°.

20. The system of at least one of the preceding Claims, wherein a beam propagating between second and third mirrors (M2, M3) along an optical path between the object (OB) and the image (IM) and a beam propagating between fourth and fifth mirrors (M4, M5) cross in the y-axis direction.

21. The system of at least one of the preceding Claims, wherein a maximum aspheric departure of a sixth mirror M6 along an optical path from the object (OB) to the image (IM) from a best fitting sphere is less than substantially 6 $\mu$m.

22. The system of at least one of the preceding Claims, wherein said system is configured to have a RMS wavefront error of 0.017$\lambda$ or less.

**Patentansprüche**

1. Optisches EUV-Projektionssystem, umfassend:

   mindestens sechs Spiegel (M1, M2, M3, M4, M5, M6) zum Abbilden eines Objekts (OB) auf ein Bild (IM) und worin mindestens ein Spiegelpaar weiterhin aufgebaut ist als ein mindestens partiell phasenkompensierendes Spiegelpaar.

2. System nach Anspruch 1, worin das mindestens partiell phasenkompensierende Spiegelpaar den zweiten Spiegel (M2) und den fünften Spiegel (M5) entlang eines optischen Wegs vom Objekt (OB) zum Bild (IM) umfasst.

3. System nach irgendeinem der Ansprüche 1 oder 2, weiter umfassend eine Blende (APE), angeordnet entlang eines optischen Wegs vom Objekt (OB) zum Bild (IM) zwischen einem ersten Spiegel (M1) und einem zweiten Spiegel (M2).

4. System nach Anspruch 3, worin die Blende (APE) nicht auf dem ersten Spiegel (M1) angeordnet ist und die Blende (APE) nicht auf dem zweiten Spiegel (M2) angeordnet ist.

5. System nach irgendeinem der Ansprüche 1 bis 4, worin ein zweiter Spiegel (M2) entlang eines optischen Wegs vom Objekt (OB) zum Bild (IM) konvex ist und ein dritter Spiegel (M3) entlang des optischen Wegs konkav ist.

6. System nach Anspruch 1, weiter umfassend:

   eine Blende (APE), angeordnet entlang eines optischen Wegs vom Objekt (OB) zum Bild (IM) zwischen einem ersten Spiegel (M1) und einem zweiten Spiegel (M2) und
   worin der zweite Spiegel (M2) konvex ist und
   worin ein dritter Spiegel (M3) entlang des optischen Wegs konkav ist.

7. System nach Anspruch 6, worin die Blende (APE) nicht auf dem ersten Spiegel (M1) angeordnet ist, und die Blende (APE) nicht auf dem zweiten Spiegel (M2) angeordnet ist.

8. System nach Anspruch 7, worin das mindestens partiell phasenkompensierende Spiegelpaar den zweiten Spiegel (M2) und den fünften Spiegel (M5) entlang des optischen Wegs aufweist.

9. System nach irgendeinem der Ansprüche 1 bis 8, worin das System aufgebaut ist, um ein Zwischenbild (IMI) entlang eines optischen Wegs vom Objekt (OB) zum Bild (IM) zwischen einem zweiten Spiegel (M2) und einem dritten Spiegel (M3) derart zu bilden, dass ein erster Spiegel (M1) und ein zweiter Spiegel (M2) eine erste optische Gruppe (G1) bilden, und ein dritter Spiegel (M3), ein vierter Spiegel (M4), ein fünfter Spiegel (M5) und ein sechster Spiegel (M6) eine zweite optische Gruppe (G2) bilden.

10. System nach Anspruch 9, worin ein Vergrößerungsverhältnis der ersten optischen Gruppe zwischen -0,8 und -1,2 liegt, und ein Vergrößerungsverhältnis der zweiten optischen Gruppe zwischen -0,15 und -0,35 liegt.

11. System nach Anspruch 1, weiter umfassend:

   worin das System aufgebaut ist, um ein Zwischenbild (IMI) entlang eines optischen Wegs vom Objekt (OB) zum Bild (IM) zwischen einem zweiten Spiegel (M2) und einem dritten Spiegel (M3) derart zu bilden, dass ein erster Spiegel (M1) und der zweite Spiegel (M2) eine erste optische Gruppe (G1) bilden, und der dritte Spiegel (M3), ein vierter Spiegel (M4), ein fünfter Spiegel (M5) und ein sechster Spiegel (M6) eine zweite optische Gruppe (G2) bilden, und
   worin der zweite Spiegel (M2) konvex ist und
   worin der dritte Spiegel (M3) konkav ist.

12. System nach Anspruch 11, weiterhin umfassend eine Blende (APE), angeordnet entlang des optischen Wegs vom Objekt (OB) zum Bild (IM) zwischen dem ersten Spiegel (M1) und dem zweiten Spiegel (M2).

13. System nach Anspruch 12, worin die Blende (APE) nicht auf dem ersten Spiegel (M1) angeordnet ist und die Blende (APE) nicht auf dem zweiten Spiegel (M2) angeordnet ist.

**14.** System nach Anspruch 13, worin das mindestens partielle phasenkompensierende Spiegelpaar den zweiten Spiegel (M2) und den fünften Spiegel (M5) aufweist.

**15.** System nach mindestens einem der vorangehenden Ansprüche, worin ein erster Spiegel (M1) entlang eines optischen Wegs vom Objekt (OB) zum Bild (IM) konkav ist, ein zweiter Spiegel (M2) konvex ist, ein dritter Spiegel (M3) konkav ist, ein vierter Spiegel (M4) konkav ist, ein fünfter Spiegel (M5) konvex ist und ein sechster Spiegel (M6) konkav ist.

**16.** System nach mindestens einem der vorangehenden Ansprüche, worin jeder der sechs Spiegel (M1, M2, M3, M4, M5, M6) zwischen dem Objekt (OB) und dem Bild (IM) angeordnet ist und worin ein physikalischer Abstand zwischen dem Objekt (OB) und dem Bild (IM) im wesentlichen 1.500 mm oder weniger beträgt.

**17.** System nach mindestens einem der vorangehenden Ansprüche, worin das System ein Bild (BI) mit einer numerischen Apertur größer als 0,18 bildet.

**18.** System nach Anspruch 17, worin jeder der sechs Spiegel (M1, M2, M3, M4, M5, M6) einen Hauptstrahl (CR) von einem zentralen Feldpunkt (COP) in einem Einfallswinkel von weniger als im wesentlichen 16° empfängt.

**19.** System nach irgendeinem der Ansprüche 17 oder 18, worin fünf der sechs Spiegel (M1, M2, M3, M4, M5, M6) einen Hauptstrahl (CR) von einem zentralen Feldpunkt (COP) bei einem Einfallswinkel von weniger als im wesentlichen 13° empfängt.

**20.** System nach mindestens einem der vorangehenden Ansprüche, worin ein Strahl, der sich zwischen dem zweiten und dem dritten Spiegel (M2, M3) entlang eines optischen Wegs zwischen dem Objekt (OB) und dem Bild (IM) fortpflanzt, und ein Strahl, der sich zwischen dem vierten und dem fünften Spiegel (M4, M5) fortpflanzt, sich in der Y-Achsenrichtung kreuzen.

**21.** System nach mindestens einem der vorangehenden Ansprüche, worin die maximale asphärische Abweichung eines sechsten Spiegels (M6) entlang eines optischen Wegs vom Objekt (OB) zum Bild (IM) von einer am besten passenden Sphäre weniger als im wesentlichen 6 μm beträgt.

**22.** System nach mindestens einem der vorangehenden Ansprüche, worin das System aufgebaut ist, um einen RMS-Wellenfrontfehler von 0,017 λ oder weniger aufzuweisen.

## Revendications

**1.** Système optique de projection UVE (ultraviolet extrême) comprenant :

au moins six miroirs (M1, M2, M3, M4, M5, M6) pour former l'image d'un objet (OB) en une image (IM), et dans lequel au moins une paire de miroirs est en outre configurée en tant que paire de miroirs compensant au moins partiellement la phase.

**2.** Système selon la revendication 1, dans lequel ladite paire de miroirs compensant au moins partiellement la phase comprend le second miroir (M2) et le cinquième miroir (M5) sur un chemin optique allant de l'objet (OB) à l'image (IM).

**3.** Système selon l'une quelconque des revendications 1 et 2, comprenant en outre un diaphragme d'ouverture (APE) situé sur un chemin optique allant dudit objet (OB) à ladite image (IM) entre un premier miroir (M1) et un second miroir (M2).

**4.** Système selon la revendication 3, dans lequel ledit diaphragme d'ouverture (APE) n'est pas placé sur le premier miroir (M1) et ledit diaphragme d'ouverture (APE) n'est pas placé sur le second miroir (M2).

**5.** Système selon l'une quelconque des revendications 1 - 4, dans lequel un second miroir (M2) sur un chemin optique allant de l'objet (OB) à l'image (IM) est convexe, et un troisième miroir (M3) sur ledit chemin optique est concave.

**6.** Système selon la revendication 1, comprenant en outre :

un diaphragme d'ouverture (APE) placé sur un chemin optique allant dudit objet (OB) à ladite image (IM) entre un premier miroir (M1) et un second miroir (M2), et

dans lequel ledit second miroir (M2) est convexe, et

dans lequel un troisième miroir (M3) sur ledit chemin optique est concave.

**7.** Système selon la revendication 6, dans lequel ledit diaphragme d'ouverture (APE) n'est pas placé sur ledit premier miroir (M1) et ledit diaphragme d'ouverture (APE) n'est pas placé sur le second miroir (M2).

**8.** Système selon la revendication 7, dans lequel ladite paire de miroirs compensant au moins partiellement la phase comprend le second miroir (M2) et le cinquième miroir (M5) sur le chemin optique.

**9.** Système selon l'une quelconque des revendications 1 - 8, dans lequel ledit système est configuré pour former une image intermédiaire (IMI) sur un chemin optique allant de l'objet (OB) à l'image (IM) entre un second miroir (M2) et un troisième miroir (M3), de façon qu'un premier miroir (M1) et un second miroir (M2) forment un premier groupe optique (G1), et qu'un troisième miroir (M3), un quatrième miroir (M4), un cinquième miroir (M5) et un sixième miroir (M6) forment un second groupe optique (G2).

**10.** Système selon la revendication 9, dans lequel un rapport de grossissement du premier groupe optique est compris entre -0,8 et -1,2, et un rapport de grossissement du second groupe optique est compris entre -0,15 et -0,35.

**11.** Système selon la revendication 1, comprenant en outre :

le fait que ledit système est configuré pour former une image intermédiaire (IMI) sur un chemin optique allant de l'objet (OB) à l'image (IM) entre un second miroir (M2) et un troisième miroir (M3), de façon qu'un premier miroir (M1) et le second miroir (M2) forment un premier groupe optique (G1), et que le troisième miroir (M3), un quatrième miroir (M4), un cinquième miroir (M5) et un sixième miroir (M6) forment un second groupe optique (G2), et

dans lequel ledit second miroir (M2) est convexe, et

dans lequel ledit troisième miroir (M3) est concave.

**12.** système selon la revendication 11, comprenant en outre un diaphragme d'ouverture (APE) placé sur ledit chemin optique allant dudit objet (OB) à ladite image (IM) entre ledit premier miroir (M1) et ledit second miroir (M2).

**13.** Système selon la revendication 12, dans lequel ledit diaphragme d'ouverture (APE) n'est pas placé sur ledit premier miroir (M1) et ledit diaphragme d'ouverture (APE) n'est pas placé sur ledit second miroir (M2).

**14.** Système selon la revendication 13, dans lequel ladite paire de miroirs compensant au moins partiellement la phase comprend le second miroir (M2) et le cinquième miroir (M5).

**15.** Système selon au moins l'une des revendications précédentes, dans lequel un premier miroir (M1) sur un chemin optique allant de l'objet (OB) à l'image (IM) est concave, un second miroir (M2) est convexe, un troisième miroir (M3) est concave, un quatrième miroir (M4) est concave, un cinquième miroir (M5) est convexe et un sixième miroir (M6) est concave.

**16.** Système selon au moins l'une des revendications précédentes, dans lequel chacun desdits six miroirs (M1, M2, M3, M4, M5, M6) est disposé entre ledit objet (OB) et ladite image (IM), et dans lequel une distance physique entre ledit objet (OB) et ladite image (IM) est pratiquement de 1500 mm ou moins.

**17.** Système selon au moins l'une des revendications précédentes, dans lequel ledit système forme une image (IM) avec une ouverture numérique supérieure à 0,18.

**18.** Système selon la revendication 17, dans lequel chacun des six miroirs (M1, M2, M3, M4, M5, M6) reçoit un rayon principal (CR) d'un point de champ central (COP) sous un angle d'incidence inférieur à sensiblement 16°.

**19.** Système selon l'une quelconque des revendications 17 et 18, dans lequel cinq des six miroirs (M1, M2, M3, M4, M5, M6) reçoivent un rayon principal (CR) d'un point de champ central (COP) sous un angle d'incidence inférieur à sensiblement 13°.

**20.** Système selon au moins l'une des revendications précédentes, dans lequel un faisceau se propageant entre les second et troisième miroirs (M2, M3) le long d'un chemin optique entre l'objet (OB) et l'image (IM) et un faisceau se propageant entre les quatrième et cinquième miroirs (M4, M5) se coupent dans la direction de l'axe y.

**21.** Système selon au moins l'une des revendications précédentes, dans lequel un écart asphérique maximum d'un sixième miroir M6 sur un chemin optique allant de l'objet (OB) à l'image (IM) par rapport à une sphère de meilleur ajustement est inférieur à sensiblement 6 $\mu$m.

**22.** Système selon au moins l'une des revendications précédentes, dans lequel ledit système est configuré pour avoir une erreur quadratique moyenne du front d'onde de 0,017$\lambda$ ou moins.

# FIG.1

EP 1 393 133 B1

EP 1 393 133 B1

# FIG.2